# EUROPEAN PATENT APPLICATION

(11) **EP 4 831 662 A1**
(43) Date of publication of application: **28.10.2026**
(21) Application number: 25845046.9
(22) Date of filing: 10.07.2025
(51) Int. Cl.: G01R 31/3835, G01R 31/392, G01R 31/367, G01R 31/396, G01R 31/52, G01R 19/12, G01R 19/165, H02J 7/00

(54) **ELECTRONIC DEVICE PERFORMING BATTERY CELL DIAGNOSIS METHOD AND CONTROL METHOD THEREFOR**

(30) Priority: 26.07.2024 KR 20240099571
(71) Applicant: LG Energy Solution, Ltd., Seoul 07335 (KR)
(72) Inventor: CHO, Woon Hyung, Daejeon 34122 (KR); KIM, Jisu, Daejeon 34122 (KR); KIM, Cheoltaek, Daejeon 34122 (KR)
(74) Representative: BCKIP Part mbB
(86) International application number: PCT/KR2025/010098
(87) International publication number: WO 2026/023949

(57) **Abstract**

Disclosed are an electronic device and a control method therefor, the electronic device comprising: an information acquisition interface that acquires voltages of a plurality of battery cells inside a plurality of battery modules included in a battery rack; a memory storing instructions; and a processor connected to the memory, wherein the processor is configured to: estimate SoCs of the plurality of battery cells in an idle state; estimate, on the basis of the SoCs of the plurality of battery cells in the idle state, SoCs of the plurality of battery modules in the idle state; perform first balancing between a plurality of first battery modules to be balanced from among the plurality of battery modules; perform second balancing between a plurality of first battery cells included in the plurality of first battery modules; and diagnose the plurality of first battery cells on which the second balancing has been performed.

## Description

### Technical Field

The present disclosure relates to an electronic device performing a method of diagnosing battery cells and a method for controlling the same.

### Background Art

Detecting battery cells with micro short circuits in early stages has become increasingly important, given that internal short circuits in the battery cells can lead to performance degradation of the battery cells and pose a safety hazard. Various research efforts are underway to detect battery cells with internal short circuits in early stages by enhancing performance of the battery management system (BMS) used in electric vehicles while maintaining a balance between the batteries used in the electrical vehicle, and thereby extending battery life and mitigating potential fire hazards.

### Detailed Description of the Invention

### Technical Goals

An objective of the example embodiments disclosed herein is to provide cell balancing and internal battery diagnosis functions using a method of diagnosing a battery cell with micro internal short circuit, based on a voltage variation of a plurality of battery cells with similar specifications after a cell balancing.

The goals to be achieved by example embodiments of the present disclosure are not limited to the objective described above, and other objectives may be inferred from the following example embodiments.

### Technical solutions

An electronic device according to an example embodiment may include an information acquisition interface for obtaining a voltage of a plurality of battery cells within a plurality of battery modules included in a battery rack, a memory configured to store an instruction, and a processor coupled to the memory, in which the processor may be configured to estimate a state-of-charge (SoC) of the plurality of battery cells in an idle state, estimate an SoC of the plurality of battery modules in an idle state based on the SoC of the plurality of battery cells in the idle state, perform a first balancing between a plurality of first battery modules subject to balancing among the plurality of battery modules, perform a second balancing between a plurality of first battery cells included in the plurality of battery modules, and, diagnose the plurality of first battery cells to which the second balancing has been performed.

The processor may be configured to refrain from performing a balancing for a predefined period of time following the performance of the second balancing.

The processor may be configured to measure a voltage variation of a target battery cell included in the plurality of first battery cells after expiration of the predefined period of time, and, when the voltage variation of the target battery cell is greater than or equal to a predefined threshold voltage variation, diagnose that an internal short circuit has occurred in the target battery cell.

The processor may determine the predefined period of time based on a threshold voltage variation of the plurality of first battery cells, and a voltage variation of the plurality of first battery cells over a unit of time.

A voltage variation of the plurality of first battery cells over a unit of time may be determined based on an internal short circuit resistance in the plurality of first battery cells.

The processor may be configured to determine, among the plurality of battery modules, a reference battery module that serves as a reference point for the first balancing based on the SoC of the plurality of battery modules,

determine battery modules each having an SoC that is within a first deviation above an SoC of the reference battery module as the plurality of first battery modules, and perform the first balancing at a first frequency until a difference between an SoC of the plurality of first battery modules and the SoC of the reference battery module falls within a second deviation.

The processor may be configured to determine, among battery cells included in each of the plurality of battery modules, respective reference battery cells that serve as a reference point for the second balancing, determine battery cells each having an SoC that is within a third deviation above an SoC of the respective reference battery cells as the plurality of first battery cells, and perform the second balancing at a second frequency until a difference between the SoC of each of the plurality of first battery cells and the SoC of the reference battery cells falls within a fourth deviation.

The first frequency may be greater than the second frequency.

The processor may be configured to estimate the SoC of the plurality of battery modules in the idle state based on a mean SoC of the plurality of battery cells in the idle state included in each of the plurality of battery modules in the idle state.

A method of diagnosing a battery cell performed by an electronic device may include estimating an SoC of the plurality of battery cells in an idle state, estimating an SoC of the plurality of battery modules in an idle state based on the SoC of the plurality of battery cells in the idle state, performing a first balancing between a plurality of first battery modules subject to a balancing among the plurality of battery modules,

performing a second balancing between a plurality of first battery cells included in the plurality of battery modules, and diagnosing the plurality of first battery cells to which the second balancing has been performed.

Detailed descriptions of other example embodiments are included in the detailed description and drawings.

### Effects of the Invention

One or more of the following effects may be expected when a suggested example embodiment is applied.

According to the example embodiments, it is possible to maintain an SOC balance between battery modules in a battery rack and between battery cells within the battery modules.

According to the example embodiments, it is also possible to diagnose a micro internal short circuit in a battery cell after performing a balancing on battery cells within a battery module based only on a voltage variance of the battery cell for a predefined period of time without using an additional equipment.

Effects of the present disclosure are not limited to those described above, and other effects may be made apparent to those skilled in the art from the following description.

### Brief Description of Drawings

FIG. 1 illustrates an interlocking relationship of an electronic device performing a method of diagnosing a battery cell according to an example embodiment.
FIG. 2 is a diagram for describing a relationship between a battery rack, a battery module, and a battery cell according to an example embodiment.
FIG. 3 is a block diagram illustrating components of an electronic device according to an example embodiment.
FIG. 4 is a diagram for describing a concept of a method of diagnosing a battery cell based on a battery balancing according to an example embodiment.
FIG. 5 is a flowchart for describing a method of diagnosing a battery cell according to an example embodiment.

### Mode for Carrying Out the Invention

Terms used in the example embodiments are selected, as much as possible, from general terms that are widely used at present while taking into consideration the functions obtained in accordance with the present disclosure, but these terms may be replaced by other terms based on intentions of those skilled in the art, customs, emergence of new technologies, or the like. Also, in a particular case, terms that are arbitrarily selected by the applicant of the present disclosure may be used. In this case, the meanings of these terms may be described in corresponding description parts of the present disclosure. Accordingly, it should be noted that the terms used herein should be construed based on practical meanings thereof and the whole content of this specification rather than being simply construed based on names of the terms.

In the entire specification, when an element is referred to as "comprising" or "including" another element, it shall not preclude the presence or addition of another element unless stated otherwise.

Throughout the specification, expression "at least one of a, b, and c" may include 'a only', 'b only', 'c only', 'a and b', 'a and c', 'b and c', or 'all of a, b, and c'.

The "terminal" referred hereinafter may be embodied as a computer or a portable device that can access a server or another terminal through a network. In the present disclosure, a computer may include, for example, a notebook computer, a desktop computer, and a laptop equipped with a web browser, and a portable device may include all kinds of handheld wireless communication devices such as a communication-based terminal, a smartphone, and tablet PC, supporting international mobile telecommunication (IMT), code division multiple access (CDMA), w-code division multiple access (W-CDMA), and long-term evolution (LTE), as a wireless communication device that guarantees portability and mobility.

In the following description, example embodiments of the present disclosure will be described in detail with reference to the drawings such that those skilled in the art can easily carry out the present disclosure. The present disclosure may be applied in many different forms and is not limited to the embodiments described herein.

Hereinafter, example embodiments of the present disclosure will be described in greater detail with reference to the drawings.

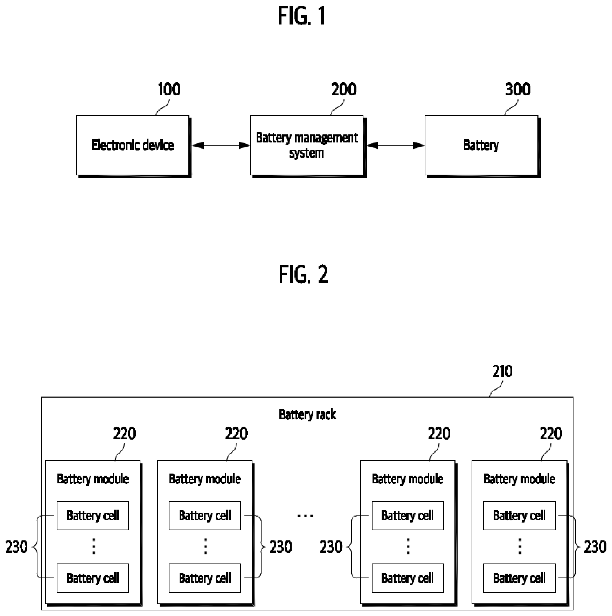

FIG. 1 illustrates an interlocking relationship of an electronic device performing a method of diagnosing a battery cell according to an example embodiment.

Referring to FIG. 1, an electronic device 100 may operate while interworking with a battery management system 200 that manages a battery 300. Here, the battery 300 may include a battery module in which a plurality of battery cells corresponding to the smallest battery unit for storing and releasing electric energy through a chemical reaction are assembled and provide a higher voltage and capacity than a single cell, and a battery rack in which a plurality of battery modules are assembled and make up a complete battery system. However, only components related to this example embodiment are shown in FIG. 1. Accordingly, it is to be understood by those skilled in the art that general-purpose components other than the components illustrated in FIG. 1 may also be included.

The electronic device 100 is a device that configures and provides various types of information. The electronic device 100 may obtain information related to a battery cell included in the battery 300. The electronic device 100 may provide a balancing function between the battery modules and a balancing function for the battery cells included in the battery modules. To ensure an optimal performance, battery life, and safety, the battery balancing may include a first balancing for equalizing the charging and discharging capacities between battery modules, and a second balancing for equalizing the charging and discharging capacities between battery cells within each of the battery modules. The electronic device 100 may provide a passive balancing function for preventing over-charging and over-discharging of a battery cell, caused by changes in capacity and voltage of the battery cell due to a difference between manufacturing properties, deterioration, and operational conditions of the battery cells forming the battery modules included in the battery rack. The passive balancing may correspond to a process of discharging excessive energy as heat by coupling a resistance to each battery cell. According to an example embodiment, the electronic device 100 may correspond to a server, an analysis equipment, or a charging device that receives a parameter related to the battery 300 from the battery management system 200 of a vehicle and instructs the battery management system 200 to perform the method of diagnosing a battery cell according to the present disclosure. The electronic device 100 may receive a parameter related to the battery 300 from the battery management system 200 and measure a voltage of the plurality of battery cells within the plurality of battery modules included in the battery 300, which is in an idle state. The electronic device 100 may be configured to estimate a state-of-charge (SoC) of the plurality of battery cells in an idle state based on the voltage, determine first battery modules subject to the first balancing among the plurality of battery modules, and perform the first balancing between the first battery modules via the battery management system 200. The electronic device 100 may be configured to diagnose each battery cell subsequent to performing the second balancing between the plurality of battery cells within the plurality of battery modules via the battery management system 200. A process of performing the diagnosis of a battery cell after performing the first balancing and the second balancing will be described herein in greater detail.

The battery management system 200 may include one or more information acquisition interfaces for estimating or measuring a parameter such as current, voltage, initial SoC, internal resistance, and internal temperature of the battery 300, and may as well include a memory and a processor (not shown) to perform various operations. That is, while the battery management system 200 may operate based on the memory and processor, similar to the electronic device 100, the battery management system 200 may also include a sensor, and measure and compute a parameter of the battery 300. In addition, as briefly described above, the battery management system 200 may similarly perform overall computation and simulation performed by the electronic device 100.

Here, while the electronic device 100 and the battery management system 200 may be completely separate and independent entities, but they may also exist in a single device or system as conceptually distinct entities. That is, according to an example embodiment, the electronic device 100 may be integrated with the battery management system 200 and control a balancing between battery modules within the battery rack included in the battery 300 of a vehicle, and diagnose for a micro internal short circuit in a battery cell after controlling a balancing between the battery cells within the battery modules. That is, a single computing device capable of controlling the battery may perform all the functions of the electronic device 100 and the battery management system 200 that are described herein, and it is understood that this example embodiment falls within the scope of the present disclosure accordingly.

FIG. 2 is a diagram for describing a relationship between a battery rack, a battery module, and a battery cell according to an example embodiment.

Referring to FIG. 2, a connection relationship between a battery rack 210, a plurality of battery modules 220, and a plurality of battery cells 230 according to an example embodiment is depicted. According to an example embodiment, the battery rack 210 may include the plurality of battery modules 220. According, to an example embodiment, each of the plurality of battery modules 220 included in the battery rack 210 may be coupled in series, and each of the plurality of battery cells 230 included in the plurality of battery modules 220 may be coupled in series. That is, the battery 300 described above with reference to FIG. 1 may have a hierarchical configuration, beginning with a battery cell that functions as the basic unit for storing and releasing electrical energy. The plurality of battery cells 230 may be grouped to form the plurality of battery modules 220 to provide a higher voltage and capacity than that of a single battery cell can store and release. The plurality of battery modules 220 may be assembled into the battery rack 210, and the battery rack 210 may serve as a framework for housing and configuring the plurality of battery modules 220, providing adequate electric connection and structural support. Hereinafter, the description of the battery module 220 may also be applied to a battery pack formed by coupling a plurality of battery cells.

The electronic device 100 and the battery management system 200 described with reference to FIG. 1 may communicate with each of the plurality of battery cells 230, monitor current, voltage, and temperature of the plurality of battery cells 230, and estimate a state-of-charge (SoC) and control charging and discharging of the plurality of battery cells 230 based on the monitoring result. The electronic device 100 and the battery management system 200 may perform the first balancing function, which corresponds to a passive balancing method that consumes energy from another battery module based on a battery module with a smallest SoC among the plurality of battery modules 220 included in the battery rack 210. The electronic device 100 and the battery management system 200 may perform the second balancing function, which corresponds to a passive balancing method that consumes energy from other battery cells within the same another battery module based on a battery cell with a smallest SoC among the plurality of battery cells 230 included in each of the plurality of battery modules 220. Then, after an expiration of a predefined period of time, the electronic device 100 may diagnose an error of a micro internal short circuit in a battery cell 230 based on a voltage variation of the plurality of battery cells 230 after the second balancing has been performed.

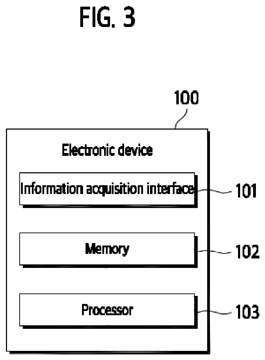

FIG. 3 is a block diagram illustrating components of an electronic device according to an example embodiment.

Referring to FIG. 3, the electronic device 100 may include an information acquisition interface 101, a memory 102, and a processor 103. Only components of the electronic device 100 related to this example embodiment are illustrated in FIG. 3. Accordingly, it is to be understood by those skilled in the art that general-purpose components other than the components illustrated in FIG. 3 may also be included.

According to an example embodiment, the information acquisition interface 101 may obtain time-series data related to a voltage of each of the plurality of battery modules and the plurality of battery cells included in the battery 300. For example, the information acquisition interface 101 may obtain a voltage value for each battery module or battery cell at a predetermined time interval, and acquire time-series data of the voltage value. That is, the time-series data may be a set of voltage values acquired at multiple time points. The information acquisition interface 101 may also obtain additional data, such as current, temperature, and state-of-charge (SoC), in addition to a voltage of a battery module or a battery cell. When the electronic device 100 performing a method of diagnosing a battery cell is a battery management system (BMS) of the battery 300, the information acquisition interface 101 may be a component that measures a voltage of the battery 300 directly, such as a voltage sensor, for example. In addition, when the electronic device 100 corresponds to an on-board diagnostics device (OBD), a server, a cloud BMS, or a charging-discharging device, the information acquisition interface 101 may be a communication interface that receives the measured voltage information from a component that measures voltage of a battery pack (e.g., a voltage sensor of the battery 300). The processor 103 may diagnose a state of each battery cell by analyzing time-series data obtained from the information acquisition interface 101. Unless stated otherwise, the processor 103 may refer to a set of one or more processors in the present disclosure.

According to an example embodiment, the memory 102, as hardware for storing various types of data processed within the electronic device 100, may be positioned within the processor 103 in the electronic device 100, and store the data processed by the processor 103 and data to be processed. In addition to storing a basic programming and data structure for providing a function of at least one example embodiment of the present disclosure, the memory may also store applications (e.g., programs, code modules, and instructions) and drivers that provide a function of an example embodiment of the present disclosure. The memory may include a random-access memory (RAM), such as dynamic random-access memory (DRAM) and static random-access memory (SRAM), a read -only memory (ROM), an electrically erasable programmable read-only memory (EEPROM), a CD-ROM, a Blu-ray or other optical disk storage, a hard disk drive (HDD), a solid-state drive (SSD), or a flash memory, but is not limited to the specific case set forth in the example embodiment of the present disclosure.

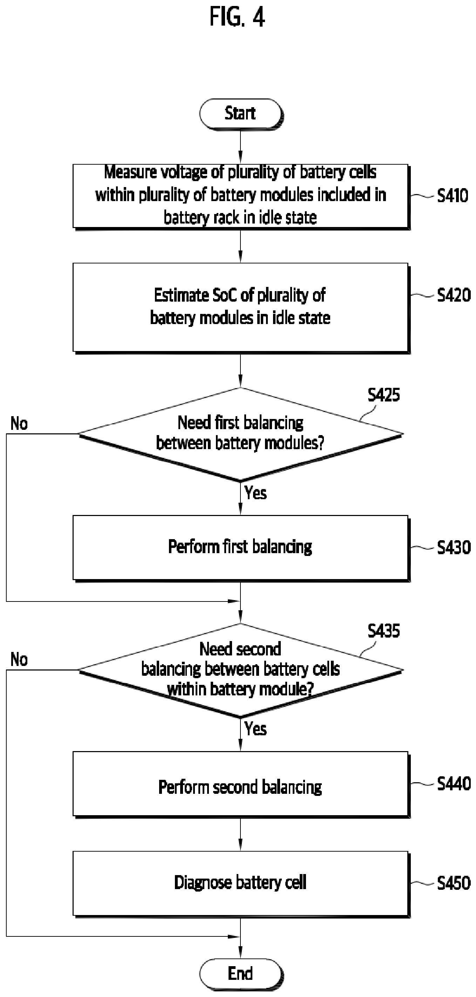

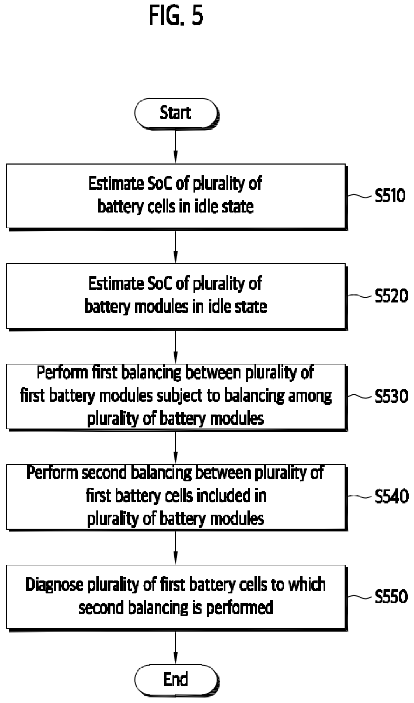

According to an example embodiment, the processor 103 may control overall operation of the electronic device 100, and process data and a signal. The processor 103 may be configured as at least one hardware unit. Also, the processor 103 may operate by one or more software modules that are generated by executing program code stored in the memory 102. As the processor 103 may include the memory 102, the processor 103 may execute program code stored in the memory 102 and control overall operation of the electronic device 100 and process data and a signal. That is, the processor 103 according to an example embodiment may be configured to estimate an SoC of the plurality of battery cells in an idle state, estimate an SoC of the plurality of battery modules in an idle state based on the SoC of the plurality of battery cells in an idle state, perform the first balancing between a plurality of first battery modules subject to a balancing among the plurality of battery modules, perform second balancing between a plurality of first battery cells included in the plurality of battery modules, and diagnose the plurality of first battery cells to which the second balancing has been performed, and this will be described in detail below with reference to FIGS. 4 and 5.

The electronic device 100 in accordance with the example embodiments described above may include a processor, a memory for storing and executing program data, a permanent storage such as a disk drive, a communication port for communication with an external device, and a user interface device such as a touch panel, key, and button. Methods realized by software modules or algorithms may be stored in a computer-readable recording medium as computer-readable code or program commands executable by the processor. Here, the computer-readable recording medium may be a magnetic storage (e.g., a read-only memory (ROM), a random-access memory (RAM), a floppy disk, and a hard disk), an optical storage (e.g., a CD-ROM, and a digital versatile disc (DVD)), or the like. The computer-readable recording medium may be dispersed to computer systems connected by a network such that computer-readable code may be stored and executed in a dispersion manner. The medium may be computer-readable, stored in a memory, and executed by a processor.

FIG. 4 is a diagram for describing a concept of a method of diagnosing a battery cell based on a battery balancing according to an example embodiment.

Referring to FIG. 4, the electronic device 100 according to an example embodiment may measure a voltage of a plurality of battery cells within a plurality of battery modules included in a battery rack in an idle state in operation S410. The electronic device 100 may measure an open circuit voltage (OCV) of the plurality of battery cells in an idle state included in each of the plurality of battery modules in an idle state.

In operation S420, the electronic device 100 according to an example embodiment may estimate an SoC of the plurality of battery cells in an idle state and estimate an SoC of the plurality of battery modules in an idle state based on the SoC of the plurality of battery cells in an idle state. For example, the electronic device 100 may estimate an SoC of each of the plurality of battery modules in an idle state based on a mean SoC of the plurality of battery cells in an idle state included in each of the plurality of battery modules in an idle state.

In operation S425, the electronic device 100 according to an example embodiment may determine whether the first balancing between the battery modules is needed. Based on this, the electronic device 100 may determine whether to perform the first balancing between the battery modules. For example, in operation S425, at the point of determining whether the first balancing is needed for the battery modules, if at least one of the battery modules has been replaced since a completion of the most recent first balancing, the electronic device 100 may determine that the first balancing between the battery modules is necessary and proceed to perform the first balancing between the battery modules. For example, the electronic device 100 may determine that the first balancing between the battery modules is not necessary and may decide not to perform the first balancing between the battery modules if differences between the SoCs of the plurality of battery modules fall within a predetermined deviation and the electronic device 100 determines that the SoCs of the battery modules are balanced.

When it is determined to perform the first balancing between the battery modules in operation S425, the electronic device 100 according to an example embodiment may determine a reference battery module and first battery modules subject to the first balancing from the plurality of battery modules in operation S430. The reference battery module may correspond to a battery module with a smallest SoC among the plurality of battery modules included in the battery rack. The first battery modules may correspond to battery modules having an SoC that is within a first deviation above an SoC of the reference battery module. For example, the first deviation may be defined as a percentage (%) value calculated based on the SoC of the reference battery module. Accordingly, if the SoC of the reference battery module is a% and the first deviation is b%, an SoC of a first battery module that is within the first deviation above the SoC of the reference battery module may be defined by Equation 1 below. [Equation 1] $a < SoC of first battery module \leq a X \left(1+\frac{b}{100}\right) \left(%\right)$

That is, the electronic device 100 according to an example embodiment may determine a battery module that exceeds the SoC of the reference battery module and having an SoC that falls within the first deviation above the SoC of the reference battery module as a first battery module. For example, based on Equation 1, if an SoC of a battery module with a smallest SoC among the plurality of battery modules is 80% and the first deviation is 10%, the electronic device 100 may determine battery modules having an SoC between 80% and 88%, inclusive, among the plurality of battery modules within the battery rack as the first battery modules.

The electronic device 100 according to an example embodiment may perform the first balancing between the first battery modules in operation S430. In this case, the first balancing may include an overall process of reducing an SoC of a first battery module by performing a passive balancing on a plurality of battery cells included in a first battery module. The electronic device 100 according to an example embodiment may perform the first balancing between the battery modules at a first frequency until SoC differences between the reference battery module and the first battery modules falls within a second deviation in operation S540. For example, the second deviation may correspond to a value smaller than the first deviation. The second deviation may be defined as a percentage (%) value calculated based on the SoC of the reference battery module. Accordingly, if the SoC of the reference battery module is a% and the second deviation is c%, an SoC of a first battery module after a last balancing which serves as a benchmark for termination of the first balancing may be defined by Equation 2 below. [Equation 2] $a < SoC of first battery module after balancing \leq a X \left(1+\frac{c}{100}\right) \left(%\right)$

For example, if a 1-1-th deviation is 10% as described above, the electronic device 100 may determine battery modules with an SoC between 80 % and 88 %, inclusive, among the plurality of battery modules in the battery rack as the first battery modules. If the second deviation, which is a condition required to terminate the first balancing, is 5%, the electronic device 100 may perform a passive balancing between the battery cells included in a first battery module until a SoC difference between the first battery module and the reference battery module falls within the second deviation. For example, if a battery module among the first battery modules has an 85% SoC before the first balancing, the electronic device 100 may perform the first balancing until the SoC of the battery module with the 85 % SoC before the first balancing reaches 84%, as an SoC range that falls within the second deviation is between 80% and 84%, inclusive, and the first balancing may then be terminated when all of the first battery modules meet this condition. In this case, the first frequency may be defined as the number of times the first balancing is performed over a period of time.

The electronic device 100 according to an example embodiment may determine whether the second balancing is needed between battery cells within a battery module in operation S435. Based on this, the electronic device 100 may determine whether the second balancing needs to be performed between battery cells within a battery module. For example, the electronic device 100 may determine that a natural SoC deviation, which is occurred between the battery cells due to manufacturing properties, deterioration, or operational conditions of the battery cells included in the battery module after the first balancing, need to be adjusted, and may proceed to perform the second balancing between the battery cells. For example, the electronic device 100 may determine that the second balancing between battery cells is not necessary and may decide not to perform the second balancing between the battery cells if a difference between an SoC of each battery cell fall within a predetermine deviation and the electronic device 100 determines that the SoCs of the battery cells within the plurality of battery modules are balanced.

When it is determined to perform the second balancing in operation S435, the electronic device 100 according to an example embodiment may determine a reference battery cell and first battery cells subject to the second balancing among the battery cells of each of the plurality of battery modules in operation S440. The reference battery cell may correspond to a battery cell having a smallest SoC among a plurality of battery cells included in a battery module. The first battery cells may correspond to battery cells having an SoC that falls within a third deviation above an SOC of the reference battery cell. For example, when an SoC of a battery cell with a smallest SoC in a battery module is 90% and the third deviation is 5%, the electronic device 100 may determine battery cells having an SoC between 90% to 94.5%, inclusive, among the plurality of battery cells within the battery module as the first battery cells.

In operation S440, the electronic device 100 according to an example embodiment may perform the second balancing between battery cells at a second frequency until SoC differences between the reference battery cell and the first battery cells fall within a fourth deviation. For example, the fourth deviation may correspond to a value smaller than the third deviation. For example, if the third deviation is 5% as stated above, the electronic device 100 may determine battery cells with an SoC between 90% and 94.5%, inclusive, among the plurality of battery cells included in a battery module as the first battery cells. If the fourth deviation, which is a condition required to terminate the second balancing, is 1%, the electronic device 100 may perform a passive balancing between the first battery cells among the plurality of battery cells included in the battery module. For example, if a battery module among the first battery cells has a 92% SoC before the second balancing, the electronic device 100 may perform the second balancing until the SoC of the battery cell with the 92% SoC before the second balancing reaches 90.9%, as an SoC range that falls within the fourth deviation is between 90% and 90.9%, inclusive, and the second balancing may then be terminated when all of the first battery cells meet this condition. In this case, the second frequency may be defined as the number of times the second balancing is performed over a period of time. As described with reference to operations S430 to S440, the electronic device 100 may sequentially perform the first balancing corresponding to a balancing between battery modules and the second balancing corresponding to a balancing between battery cells included in the battery modules. In this case the first deviation for the first balancing and the third deviation for the second balancing may be different, and, the second deviation for the first balancing and the fourth deviation for the second balancing may be different. According to an example embodiment, by taking a replacement cycle for a battery module into account, the electronic device 100 may perform the first balancing between battery modules more often than the second balancing between battery cells within the battery modules. That is, the electronic device 100 according to an example embodiment may configure the first frequency for the first balancing to be greater than the second frequency for the second balancing, and perform the first balancing and the second balancing.

According to an example embodiment, the electronic device 100 may perform a battery cell diagnosis for a first battery cell to which the second balancing has been performed in operation 450. For example, the electronic device 100 may not perform a balancing for a predefined period of time after the second balancing is performed. For example, the electronic device 100 may perform a balancing between battery cells for a predefined period of time or suspend the balancing to prevent the capacity of the battery cells from being consumed by usage. Subsequent to expiration of the predefined period of time, the electronic device 100 may measure a voltage variation of a target battery cell included in the plurality of first battery cells and, if the voltage variation of the target battery cell is greater than or equal to a predefined threshold voltage variation, diagnose that an internal short circuit has occurred in the target battery cell. Subsequent to expiration of the predefined period of time, the electronic device 100 may measure a voltage variation of a target battery cell included in the plurality of first battery cells and, if the voltage variation of the target battery cell is less than a predetermined threshold voltage variation, diagnose that an internal short circuit has not occurred in the target battery cell. For example, when a micro internal short circuit occurs in a battery cell, an internal short circuit resistance develops, and this internal short circuit resistance may be determined by Equation 3 below. [Equation 3] $R = \frac{dV}{dC} \times T$

In Equation 3, R may denote an internal short circuit resistance, dV may denote a voltage variation of a battery cell caused by an internal short circuit over a unit of time, dC may denote a leakage capacity over a unit of time caused by the internal short circuit of the battery cell, and T may denote a duration of the internal short circuit of the battery cell. That is, the voltage variation of the battery cell over a unit of time may be determined based on the internal short circuit resistance of the plurality of first battery cells.

For example, the leakage capacity caused by the internal short circuit in the battery cell may be defined by Equation 4 below. [Equation 4] ${Capacity}_{ISC} \left[Ah\right] = \frac{{V}_{nominal}}{{R}_{ISC}} ∗ t$

In Equation 4, *R_{ISC}* may denote an internal short circuit resistance, *Vₙₒₘᵢₙₐₗ* may denote a nominal voltage of a battery cell, *Capacity_{ISC}* may denote a leakage capacity caused by the internal short circuit in the battery cell, and ***t*** may denote a duration of the internal short circuit in the battery cell. That is, the electronic device 100 may identify the leakage capacity caused by the internal short circuit in the battery cell when the nominal voltage, the internal short circuit resistance, and the duration of the internal short circuit of the battery cell are identified, and determine a predefined period of time that satisfies a predefined leakage capacity caused by the internal short circuit and identify a voltage variation of a corresponding battery cell based on Equation 4.

For example, when a micro internal short circuit in a battery cell leads to a 1kΩ internal short circuit resistance, a 0.22 millivolt (mV) voltage may decrease per day (24 hours) due to the internal short circuit, which translates to a voltage variation of 0.22mV over a 24-hour unit of time, and consequently, a threshold voltage variation of 11mV may need to be confirmed to diagnose the internal short circuit in the battery cell. The electronic device 100 according to an example embodiment may determine a predefined period of time of approximately 50 days, and, if a voltage variation of a particular battery cell measured at the time point after expiration of the 50 days of predefined period of time since the second balancing was performed is greater than or equal to 11mV, diagnose that an internal short circuit has occurred in the particular battery cell. The electronic device 100 according to an example embodiment may diagnose whether an internal short circuit has occurred in a battery cell, based on a mean value of differences between voltages of the plurality of battery cells after the second balancing has been performed and voltages of the plurality of battery cells after expiration of the predefined period of time. For example, if a difference between a voltage of a particular battery cell after performing the second balancing and a voltage of the particular battery cell after expiration of the predefined period of time is greater than a mean value of a difference between voltages of the plurality of battery cells to which the second balancing is performed and voltages of the plurality of battery cells after expiration of the predefined period of time, the electronic device 100 may diagnose that an internal short circuit has occurred in the particular battery cell. In the basis that battery cells within the same battery module possess similar properties, the electronic device 100 may assume that their voltage variations will be similar even when they are left idle for the same predefined period of time without charging or discharging, and diagnose a particular battery cell that exhibits a greater voltage reduction than other battery cells over the same period of time as having an internal micro-short- circuit.

FIG. 5 is a flowchart for describing a method of diagnosing a battery cell according to an example embodiment.

Referring to FIG. 5, in operation S510, the electronic device 100 according to an example embodiment may measure a voltage of a plurality of battery cells within a plurality of battery modules included in a battery rack in an idle state.

According to an example embodiment, in operation S520, the electronic device 100 may estimate an SoC of the plurality of battery cells in an idle state and estimate an SoC of the plurality of battery modules in an idle state based on the SoC of the plurality of battery cells in idle state. As described above, the electronic device 100 may estimate an SoC of each of the plurality of battery modules in an idle state based on a mean SoC of the plurality of battery cells in an idle state included in each of the plurality of battery modules in an idle state.

In operation S530, the electronic device 100 according to an example embodiment may perform the first balancing between a plurality of first battery modules subject to a balancing among the plurality of battery modules. For example, as described above, when at least one of the plurality of battery modules has been replaced after a previous first balancing between the battery modules is performed, the electronic device 100 may perform the first balancing between the battery modules, determine a reference battery module corresponding to a battery module with a smallest SoC in the battery rack, and then perform the first balancing at the first frequency until SoCs of first battery modules with an SoC that falls within the first deviation above an SoC of the reference battery module fall within the second deviation above the SoC of the reference battery module.

In operation S540, the electronic device 100 according to an example embodiment may perform the second balancing between pluralities of first battery cells included in the plurality of battery modules. The electronic device 100 according to an example embodiment may perform the second balancing between a plurality of first battery cells included in a first battery module to which the first balancing has been performed, and may also perform the second balancing between a plurality of first battery cells included in a battery module other than the first battery module to which the first balancing has been performed among the plurality of battery modules. For example, as described above, the electronic device 100 may perform the second balancing between battery cells included in each battery module to adjust a natural SoC deviation, may determine reference battery cells corresponding to a battery module with a smallest SoC among the plurality of battery cells included in each battery module, and perform the second balancing at the second frequency until SoCs of the first battery cells corresponding to battery cells with an SoC that falls within the third deviation above the SoC of the reference battery cell fall within the fourth deviation above the SoC of the reference battery module . The electronic device 100 may configure the second frequency for the second balancing to be smaller than the first frequency for the first balancing and then perform the first balancing and the second balancing.

According to an example embodiment, the electronic device 100 may perform a battery cell diagnosis for the plurality of first battery cells to which the second balancing has been performed in operation S540. For example, subsequent to the second balancing, the electronic device 100 may refrain from performing both the first balancing and the second balancing for a predefined period of time, and may diagnose for an internal short circuit in a battery cell by monitoring a voltage deviation between a normal battery cell and a battery cell with an internal short circuit. The electronic device 100 may measure a voltage variation of a target battery cell included in the plurality of first battery cells, and, when the voltage variation of the target battery cell is greater than or equal to a predefined threshold voltage variation, diagnose that an internal short circuit has occurred in the target battery cell. The electronic device 100 may determine the predefined period of time based on the threshold voltage variation of the plurality of first battery cells and the voltage variation of the plurality of first battery cells over a time. The voltage variation of the plurality of first battery cells over a unit of time may be determined based on an internal short circuit resistance of the plurality of first battery cells.

However, example embodiments of the present disclosure are set forth in the present specification and the drawings, and although specific terms are used herein, the terms used are provided in a general sense to easily explain the technical idea of the present disclosure and help understanding of the present disclosure only, and are not intended to limit the scope of the present disclosure. It will be apparent to those skilled in the art that other modified examples based on the technical spirit of the present disclosure may be implemented.

The example embodiments may be represented by functional blocks and various processing steps. These functional blocks may be implemented by various numbers of hardware and/or software configurations that execute specific functions. For example, the example embodiments may adopt direct circuit configurations such as a memory, a processor, a logic circuit, and a look-up table that may execute various functions by control of one or more microprocessors or other control devices. Similar to that, elements may be executed by software programming or software elements, the example embodiments may be implemented by programming or scripting languages such as C, C++, Java, and assembler including various algorithms implemented by combinations of data structures, processes, routines, or of other programming configurations. Functional aspects may be implemented by algorithms executed by one or more processors. In addition, the example embodiments may adopt the related art for electronic environment setting, signal processing, and/or data processing, for example. The terms "mechanism", "element", "means", and "configuration" may be widely used and are not limited to mechanical and physical components. These terms may include meaning of a series of routines of software in association with a processor, for example.

The example embodiments described above are merely examples and other embodiments may be implemented within the scope of the following claims.

## Claims

1. An electronic device comprising:
an information acquisition interface for obtaining a voltage of a plurality of battery cells within a plurality of battery modules included in a battery rack;
a memory configured to store an instruction; and
a processor coupled to the memory,
wherein the processor is configured to:
estimate a SoC of the plurality of battery cells in an idle state,
estimate a SoC of the plurality of battery modules in an idle state based on the SoC of the plurality of battery cells in the idle state,
perform a first balancing between a plurality of first battery modules subject to balancing among the plurality of battery modules,
perform a second balancing between a plurality of first battery cells included in the plurality of battery modules, and
diagnose the plurality of first battery cells to which the second balancing has been performed.

2. The electronic device of claim 1, wherein the processor is configured to refrain from performing a balancing for a predefined period of time following the performance of the second balancing.

3. The electronic device of claim 2, wherein the processor is configured to measure a voltage variation of a target battery cell included in the plurality of first battery cells after expiration of the predefined period of time, and,
when the voltage variation of the target battery cell is greater than or equal to a predefined threshold voltage variation, diagnose that an internal short circuit has occurred in the target battery cell.

4. The electronic device of claim 2, wherein the processor determines the predefined period of time based on a threshold voltage variation of the plurality of first battery cells, and a voltage variation of the plurality of first battery cells over a unit of time.

5. The electronic device of claim 3, wherein the voltage variation of the plurality of first battery cells over the unit of time is determined based on an internal short circuit resistance in the plurality of first battery cells.

6. The electronic device of claim 1, wherein the processor is configured to:
determine, among the plurality of battery modules, a reference battery module that serves as a reference point for the first balancing based on the SoC of the plurality of battery modules;
determine battery modules each having an SoC that is within a first deviation above an SoC of the reference battery module as the plurality of first battery modules; and
perform the first balancing at a first frequency until a difference between an SoC of the plurality of first battery modules and the SoC of the reference battery module falls within a second deviation.

7. The electronic device of claim 6, wherein the processor is configured to:
determine, among battery cells included in each of the plurality of battery modules, respective reference battery cells that serve as a reference point for a second balancing;
determine battery cells each having an SoC that is within a third deviation above an SoC of the respective reference battery cells as the plurality of first battery cells; and
perform the second balancing at a second frequency until a difference between the SoC of each of the plurality of first battery cells and the SoC of the reference battery cells falls within a fourth deviation.

8. The electronic device of claim 7, wherein the first frequency is greater than the second frequency.

9. The electronic device of claim 1, wherein the processor is configured to estimate the SoC of the plurality of battery modules in the idle state based on a mean SoC of the plurality of battery cells in the idle state included in each of the plurality of battery modules in the idle state.

10. A non-transitory computer-readable storage medium to which a program for executing any one method of claims 1 to 9 is written.

11. A method of diagnosing a battery cell performed by an electronic device, the method comprising:
estimating an SoC of a plurality of battery cells in an idle state;
estimating an SoC of a plurality of battery modules in an idle state based on the SoC of the plurality of battery cells in the idle state;
performing a first balancing between a plurality of first battery modules subject to a balancing among the plurality of battery modules;
performing a second balancing between a plurality of first battery cells included in the plurality of battery modules; and
diagnosing the plurality of first battery cells to which the second balancing has been performed.
